# EUROPEAN PATENT SPECIFICATION

(11) **EP 0 422 299 B1**
(45) Date of publication and mention of the grant of the patent: **07.09.1994**
(21) Application number: 89310459.6
(22) Date of filing: 12.10.1989
(51) Int. Cl.: G09G 1/16, G11C 7/00, G11C 11/409

(54) **Memory with page mode**
Speicher mit Seitenmodus
Mémoire avec mode de page

(43) Date of publication of application: 17.04.1991
(73) Proprietor: International Business Machines Corporation, Armonk, N.Y. 10504 (US)
(72) Inventor: West, Roderick Michael Peters, Chandlers Ford Hampshire. SO5 1TG (GB); Bates, Matthew Damian, Shirley Southampton Hampshire. SO1 6DA (GB); Gay, Adrian Charles, Fareham Hampshire. PO15 6LE (GB); Williams, Todd, Essex Junction Vermont. 05452 (US)
(74) Representative: Burt, Roger James, Dr.

(56) References cited:
- WO-A-82/04147
- US-A- 4 546 451

## Description

### FIELD OF THE INVENTION

The invention relates to a memory operable under page mode.

### BACKGROUND OF THE INVENTION

Memories such as random access and read only memories which are randomly addressable are usually arranged as a matrix of storage locations or groups of storage locations which are addressable by row and by column. Various organisations of memory locations are possible. For example, a 1Mbit memory can be arranged as 256K words of 4 bits addressable on 512 rows and 512 columns so that addressing a specific row and column gives access to a group of 4 storage locations. An alternative organisation is as 128K words of 8 bits addressable either on 512 rows and 256 columns or 256 rows and 512 columns so that addressing a specific row and column gives access to a group of 8 storage locations. It will be appreciated that these are just two of many possible organisations.

There are many different types of randomly addressable memories. Examples are read only memories (ROMs), programmable ROMs (PROMs), static random access memories (SRAM), dynamic RAM (DRAM) and video RAM (VRAM), the latter being a specific type of DRAM. These memories are normally accessed by first selecting a row and then selecting a column within the memory in response to timing signals termed RAS (row address strobe) and CAS (column address strobe), respectively. During such normal accessing of the RAM the row address cycles alternate with column address cycles, each pair of row and column cycles allowing access to the bit or bits having a specified row and column address.

In some memories however, an additional access method, generally termed "page mode", is provided in accordance with which multiple column cycles are performed within a single row cycle. The term "static column mode" has been used for this type of mechanism. However, the term "page mode" is widely understood in the art as being a generic term covering this type of access mechanism. Conventionally, a row address is selected for a page mode row cycle and, within that row cycle, multiple column cycles are performed to access the memory at selected column addresses in that row. By avoiding the need for a new row address strobe to be provided each memory access, fast access can be had to data occurring within a single row.

One application for RAM is as an all points addressable (APA) display memory in a display system. In modern APA raster displays, an image to be viewed is stored point-by-point as picture element (pixel) data in a memory subsystem frame buffer, comprised of dynamic random access memory (DRAM) or video random access memory (VRAM). These designs allow arbitrary update of pixel contents for display of arbitrarily complex images.

The information stored is either periodically refreshed to restore the image on the video monitor or is updated to modify the displayed image. For raster scan displays, horizontal line updates generally occur in page mode, wherein data on an accessed row is updated in multiple column locations, corresponding to adjacent pixels on a scan line, for enhanced update bandwidth. However, vertical line updates generally require multiple sequential row accesses to perform image modification at random cycle time performance, as much as four times longer than that of page mode update.

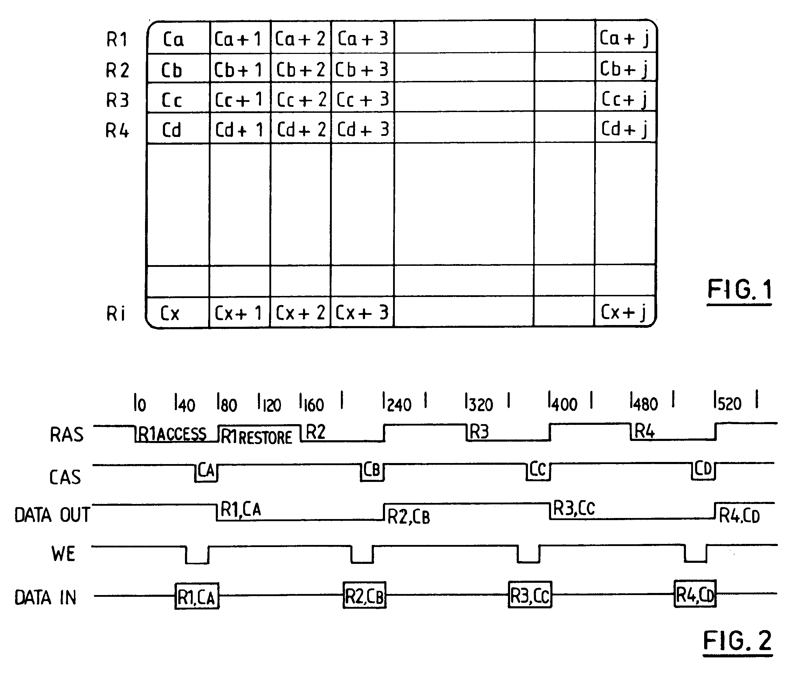

Referring to Figure 1, assume that pixel data for a horizontal line is stored along adjacent column locations in a row of memory (eg. C[a], C[a+1], C[a+2], etc.) while vertical lines are stored in a column across multiple rows (eg. C[a], C[b], C[c], etc.). It will be appreciated that other storage conventions may be used. In this general case, page mode can be used for plotting straight horizontal lines by simply accessing sequential storage cells on a row in page mode. However, page mode provides no benefit for vertical lines, and little, if any benefit for lines at intermediate angles or for curves. As shown in Figure 2, continuous RAS cycles are needed to access each pixel, C[a], C[b], C[c], along a given vertical line. As a result, performance decreases dramatically for continuous row-to-row accesses.

### SUMMARY OF THE INVENTION

The primary problem the inventors had to address was a solution to the spatial difference in updating or plotting performance of a display. On analysing the problem it was realised that it resulted from the basic hardware constraints of random access memories with page mode.

An object of the invention was, therefore, to provide a memory which provided the speed advantages of page mode, without the disadvantages mentioned above.

In accordance with the invention, there is provided a memory addressable by row and by column and operable in page mode such that a row address is selected for a row cycle and within said row cycle a plurality of column cycles are performed to access the memory at selected column addresses, characterised in that said memory additionally comprises control means for stepping the row address for selected column cycles within said row cycle.

The terms "row" and "column" are used herein as labels for first and second dimensions of memory; this being the conventional nomenclature in the art. These terms "row" and "column" are thus to be understood as such; that is simply as labels for a first and for a second memory dimension respectively. Similarly, the term "page mode" is to be understood as a generic term covering an access mechanism enabling, within an access cycle for a first memory dimension, multiple accesses for a second memory dimension. Thus, the term "page mode" is to be interpreted herein as covering a memory access mechanism sometimes referred to as "static column mode" and other such access mechanisms.

The invention is applicable to all memories operable under such modes, including SRAM, DRAM, VRAM, various types of ROM. Indeed, although examples of the invention are described for memories which are organised in two-dimensions and receive two address components (ie. row and column), the invention is also applicable to memories which are organised with more than two dimensions and receive address components for each dimension.

Preferably, the control means is responsive to a row change signal (RC) supplied to said memory when a column address strobe (CAS) becomes active to step said row address. The stepping of the row address for a particular column cycle within a row cycle can thereby be achieved with a minimum of additional information. By predefining a step to be made in response to a row change signal, then a single bit can be used to specify whether that step should occur or not for a given column cycle.

In order that the step to be performed can be predefined in a programmable manner, the control means is preferably responsive to a mode signal supplied to said memory when a row address strobe becomes active to set said memory in a selected row change mode. This row change mode then defines a row address step performed by said control means in response to any row change signal within that row cycle. For example, the step could be an increment or a decrement by an amount defined by the memory hardware or, for example, by values in a register.

Where the memory is set in either a row increment mode or a row decrement mode in response to said mode signal, the control means is preferably responsive to a row address supplied to the memory when said row address strobe becomes active to activate the row selected by said row address and at least one row having a higher address in a row increment mode or a lower address in a row decrement mode. In this way, a second row is already activated should, during the row address cycle, a row change signal be supplied to the memory. If the incremental or decremental amount mentioned above, is plus or minus one, the activated rows will have adjacent row addresses.

Advantageously, in the case where a plurality of rows are activated simultaneously, a change in the rows activated is made when the row address is stepped in response to a row change signal.

In a preferred form of the invention, the memory is segmented into at least two segments such that at least one row address bit in a row address is used to select a memory segment and the remainder of the row address bits are used to select a row within each segment. Memory segmentation is employed in large memories in order to reduce the loading on individual rows and columns. This decreases signal generation and propagation delays while reducing both variation in data rates and power consumption. For a memory in accordance with the invention, the segmentation of the memory also enables the simplification of the simultaneous activation of a plurality of rows by placing logically sequential rows in physically separate subarrays.

The row change direction signal and/or the row change signal can be supplied on a dedicated control line to the memory. This control line can be shared between the row change direction signal and the row change signal as they are supplied at different times. Aternatively, they can be supplied in any other suitable way to the memory. For example, they could be included on a line or lines which are unused at the time when these signals need to be supplied, or could be stored as part of an instruction stored in a register.

A random access memory in accordance with the invention finds particular, but not exclusive application as a display memory for a display system. Accordingly, the invention also relates to display memory comprising a random access memory as defined above and a display system incorporating a display memory. The invention also relates to a method of accessing a random access memory and a method of plotting a line in a display system incorporating such a random access memory.

### BRIEF DESCRIPTION OF THE DRAWINGS

Raster scan bit mapping with prior art RAM design limitations, an implementation of a memory in accordance with the invention and a workstation incorporating such a memory are described hereinafter with reference to the accompanying drawings, in which:
- Figure 1 illustrates a typical organisation of display data within a display memory;
- Figure 2 is a timing diagram of conventional RAM operation for vertical line update accessing sequential rows in a display memory, consistent with a memory having random access cycle time of 160ns.;
- Figure 3 is a timing diagram for vertical line draw in an example of a memory in accordance with the invention consistent with a memory having random access cycle time of 160ns. and a page mode cycle time of 40ns.;
- Figure 4 is an embodiment of the invention having means of accessing multiple subarray rows in a manner consistent with the timing diagram in Figure 3;
- Figure 5 illustrates a physical chip implementation showing physical row placement in memory subarrays, consistent with the embodiment in Figure 4; and
- Figure 6 is a schematic block diagram of a display system in which the present invention may be incorporated.

Figure 1 illustrates a typical display memory, or frame buffer, bit map of a raster scan display, showing row and column locations of pixel data stored in the RAM. Horizontal updates are shown to lie on a row across multiple column addresses (R[1], C[a]-C[a+j]), accessible in page mode, while vertical lines are shown to lie across multiple rows at a given column address (R[1]-R[i], C[a,b,c,d]).

Figure 2 shows the timing sequence necessary to update pixel data for a vertical line in a frame buffer comprised of conventional RAM using random row cycle timings, consistent with a memory having random access cycle time of 160ns. In each cycle a row is accessed, data written (or read), the row is refreshed, and a subsequent row is accessed.

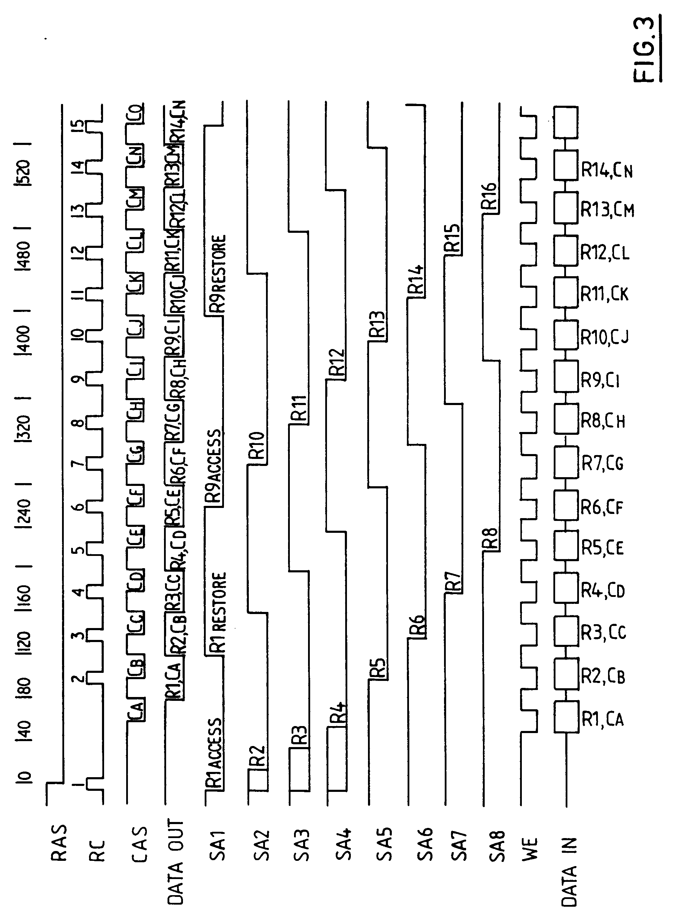

Figure 3 shows timings associated with an embodiment of this invention for the same timing case as that of Figure 2. Page mode timings with internal row activation are shown for both read and write cycles. Timings assume a 4:1 difference between random RAS (160ns.) and page mode cycles (40ns.). All timing figures are drawn with the same performance assumptions. The timings show initial row accesses occurring in both staggered and simultaneous manner demonstrating the viability of both approaches.

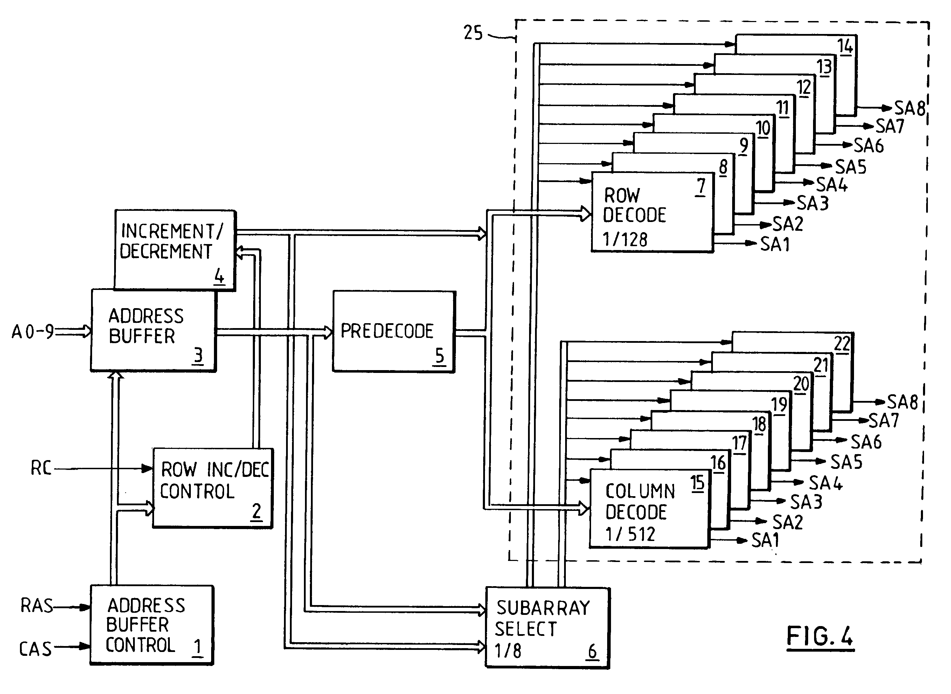

Figure 4 illustrates the control elements required for the addressing and timing sequences within a random access memory in accordance with the invention and consistent with the timings shown in Figure 3. The random access memory illustrated is a 4Mb memory, organised as 512K by 8, with 1024 rows by 512 columns by 8 data bits.

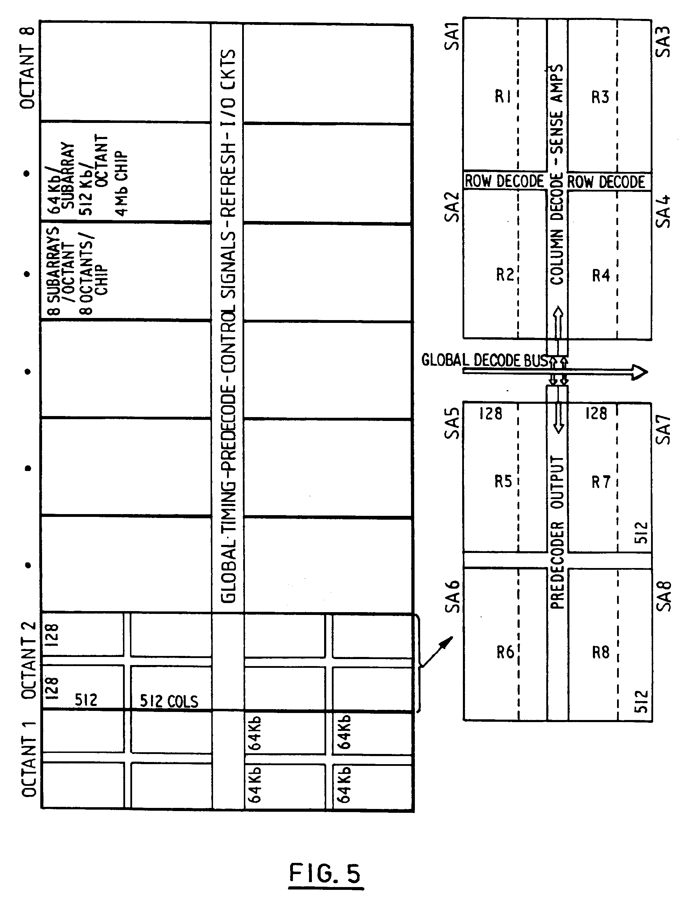

Figure 5 illustrates an example of array segmentation for a 4Mb random access memory with subarrays in support of the timings and block diagrams in Figures 3 and 4. The memory consists of 8 array blocks or octants (512 Kb) which are further subdivided into 8 subarrays (64Kb). Each subarray is independently operable under control of global logic of Figure 4 when operating in the row increment-decrement mode.

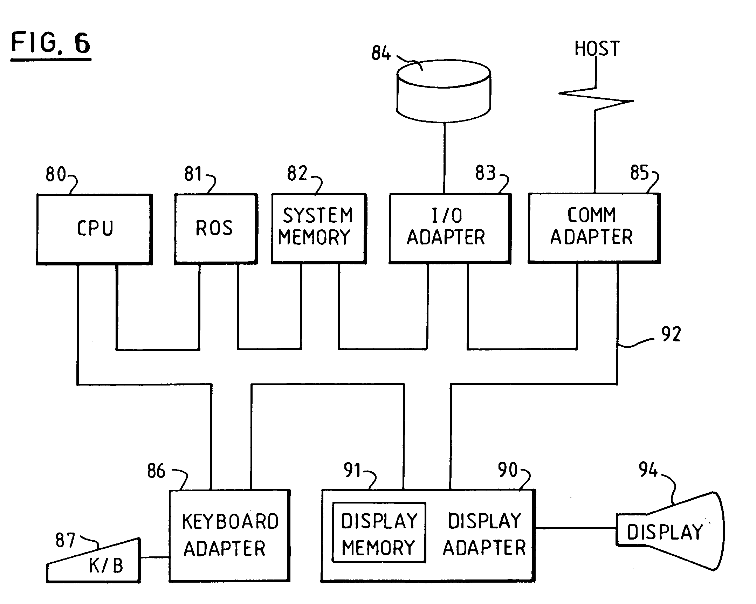

Figure 6 is an example of a typical workstation graphics display subsystem using memory in accordance with the invention to enhance overall system performance.

### DETAILED DESCRIPTION OF AN EMBODIMENT OF THE INVENTION

A description of an embodiment of this invention will be explained by reference to the internal and external memory timings of Figure 3. In the implementation assumed, RC is introduced as a control signal performing the following functions:
1. At the falling RAS transition, it indicates the direction in which subsequent row accesses will occur:
   - if RC=0 row addresses will be decremented,
   - if RC=1 row addresses will be incremented.
2. At the falling CAS transition, it indicates when such a row change will occur:
   - if RC=0 access will occur at the specified column address on the present row (R),
   - if RC=1 access will occur at the specified column address on the next row address (R±1) from the present address (R), as specified in Step 1.

Although increment or decrement by one is examined, consistent with the graphics examples cited, changes of address by other predetermined amounts could be implemented by design or programmed in storage registers using RC to select the desired register. A given design architecture could support multiple increment or decrement values. In these timings a random cycle time of 160ns and page mode cycles of 40ns are used. This performance ratio (4:1) is typical of many random access memory designs with so-called "Fast Page Mode". The case shown demonstrates row increment based on a screen origin (0,0) in the upper left corner (Figure 1) for a vertical line with one column address update per row. Implementing the functional requirements of these timings requires the following RAM architecture and circuit enhancements:
- Physical separation of rows within the increment range into distinct subarrays (Figure 5).
- Additional supporting circuitry and control logic for independent simultaneous subarray operation, multiple subarray row decode activation, mode selection and internal row increment/decrement and restore operations (Figure 4).

At the initial falling RAS transition, the row change signal (RC) is positive, indicating logical row address increments are to occur for subsequent row changes specified within the initiated RAS cycle. On the initial access, the addressed row is selected (R1 in subarray SA1) as well as the next 3 rows (R2,R3,R4) in their respective subarrays (Figure 5). Accesses to each of these subarrays may be staggered to reduce power dissipation and chip supply switching noise. Variations in parameters for optimisation of the chip design must be considered when implementing the features described herein.

On the first falling CAS transition, the row change signal (RC) is negative indicating data access is to occur at the original row, R1, and at the column address specified, C[A].

On the second falling CAS transition, RC is positive directing access to the next row address, R2, and at the column address specified, C[B]. At that time, row R5 is activated in anticipation of subsequent row changes.

On the subsequent rising CAS transition, R1 is restored, after R5 access, to reduce power and noise generation. Row restore and access cycles may occur on either CAS edge and will be inherent in the control logic timing. After completion of R1 restore, subarray SA1 will be available for subsequent row access. This occurs as an access to R9 after row selection has stepped through each of the intervening subarrays. Determination of the number of subarrays and the number of initially accessed rows is made by consideration of chip architecture, RAS and CAS cycle times, word line segmentation, chip density and subarray restore time.

On each following falling CAS transition, RC invokes a row change. For the timings shown, row accesses occur sequentially in each subarray and return to subarray SA1 for row R9, by which time, row R1 in subarray SA1 has been properly restored. These timings provide row preselect and restore under control of additional logic circuitry with sufficient lead time to assure seamless data transfer at page mode data rates. For example, row R5 is selected in subarray SA5 by the second falling CAS transition. Data is available two CAS cycles later and is accessed in the next CAS cycle (C[E]). The positive transition of the second CAS cycle also restores row R1 in subarray; restore being completed and subarray SA1 being available for row selection in cycle C[E]. Row R9 is selected in subarray SA1 in the cycle C[F] in response to RC. Data from row R9 becomes available in cycle C[H] and is accessed in cycle C[I].

Should RC remain negative at a given falling CAS transition, column accesses will continue in the present row as a normal page mode operation. New row selection and restore is delayed until RC specifies the present row is no longer needed and new rows are accessed. Page mode rates and timings are maintained. Write enable and data-in update timings are also indicated in the timings. CAS addressing is unchanged from that of normal page mode operation.

The process continues for subsequent cycles until RAS, returning to a high level, terminates chip select. In the example described, the row change signal specifies a new row is to be accessed in the current CAS cycle. Alternatives, such as specifying RC in one CAS cycle to be executed in the following CAS cycle, could also be incorporated in the control logic. The arrangement adopted provides flexibility, has no element of lookahead, requires no empty cycles or synchronisation and represents an advantageous implementation of the invention consistent with the general class of graphic adapters and system caches.

Figure 4 is a circuit block diagram illustrating the control elements required for the addressing and timing sequences within a random access memory in accordance with the invention and consistent with the timings shown in Figure 3. The addressing subsystem illustrated is for a 4Mb random access memory, organised as 512K by 8, with 1024 rows by 512 columns by 8 data bits. Such a memory device requires 10 row address bits and 9 column address bits, which are provided through the 10 bit address input A0-9 shown in Figure 4. As illustrated in Figure 5, the memory array is physically divided into 8 octants of 512K one-bit memory locations associated with each data input/output. Each octant is further subdivided into 8 subarrays, each subarray being addressed by the low-order 3 bits of the row address. The decoder circuitry 25 in Figure 4 is repeated eight times, once for each of the eight octants. Each subarray is organised as 128 rows by 512 columns, with a single bit of data associated with each row/column pair. The subarray rows are addressed by the high-order 7 bits of the row address. The subarray columns are addressed by the 9 bit column address.

Figure 4 illustrates the circuit blocks and control signals/buses of the addressing subsystem for a conventional random access memory with the addition of circuit blocks and control signals/buses for a random access memory in accordance with the invention. The additional circuit blocks are the Row Increment/Decrement Control circuit 2 and the Increment/Decrement circuit 4. The additional control signals/buses are those to and from the additional circuit blocks.

The address buffer control circuit 1 supervises the address multiplexing of the address buffer 3. The row address and the column address are obtained, at the falling transitions of RAS and CAS respectively, from the address input A0-9. The address buffer control circuit 1 also supervises the operation of the row increment/decrement control circuit 2 which obtains row change direction and row stepping instructions, at the falling transitions of RAS and CAS respectively, from the row change input RC. The address buffer control circuit 1 generates the timing information for the addressing subsystem of the random access memory from the RAS and CAS inputs.

For a conventional single row memory access, at the falling transition of RAS, the row address is passed from the address buffer 3 through the predecoder 5 to the row decoders 7-14 which decode the most significant seven bits of the row address. The least significant three bits of the row address are passed from the address buffer 3 to the subarray select circuit 6 that determines which of the eight subarrays is being addressed. The subarray select circuit 6 selects one of the eight subarrays causing one of the row decoders 7-14 to access the addressed row. At the falling transition of CAS, the column address is passed from the address buffer 3 through the predecoder 5 to the column decoders 15-22 which decode the nine bit column address to determine which of the 512 columns is being addressed. The subarray select circuit 6 controls which of the eight subarray column decoders is selected.

When operating in row increment/decrement page mode, row addressing is performed by the increment/decrement circuit 4 under control of the row increment/decrement control circuit 2 using RC for row address selection and RAS/CAS timing information from the address buffer control circuit 1. Column addressing remains unchanged.

On the falling transition of RAS, the initial row address is passed from the address buffer 3 to the increment/decrement circuit 4. The row change direction is obtained by the row increment/decrement control circuit 2 from the level of the RC input at the falling transition of RAS. The most significant seven bits of the initial row address are passed, by the increment/decrement circuit 4, to the row decoders 7-14. The increment/decrement circuit 4 directs the subarray select circuit 6 to select one of the eight subarrays, based on the least significant three bits of the initial row address, in order to start access to the initially addressed row. The increment/decrement circuit 4 also directs the subarray select circuit 6 to select further subarrays to initiate access to further logically sequential rows.

On falling transitions of CAS, column addresses are passed from the address buffer 3 through the predecoder 5 to the column decoders 15-22. Row change instructions are obtained by the row increment/decrement control circuit 2 from the level of the RC input at the falling transitions of CAS. The increment/decrement circuit 4 directs the subarray select circuit 6 to select the column decoder of the subarray for the row being addressed in the active CAS period. Under the direction of the increment/decrement circuit 4, in response to row change instructions, the subarray select circuit 6 executes the stepping sequence of row increment/decrement by changing the selects to the subarray row decoders 7-14. To initiate access to further sequential rows, the subarray select circuit 6 activates the select to the subarray row decoder that is next in the sequence. The increment/decrement circuit 4 supplies the most significant seven bits of the row address to the newly selected row decoder. To initiate row restore for rows that have been passed in the sequence, the subarray select circuit 6 deactivates the select to the affected row decoder.

Memory in accordance with this invention can be used for the frame buffer of a graphics display system such as that shown in Figure 6 in the form of a workstation. The workstation is comprised of a central processing unit 80 in the form of a conventional microprocessor and a number of other units including a display adapter 90 which incorporates the display memory 91. The various units are connected to the microprocessor via a system bus 92. Connected to the system bus are a system memory 82 and a read only store (ROS) 81. The operation of the microprocessor is controlled by operation system and application code stored in the ROS and RAM. An I/O adapter 83 is provided for connecting the system bus to the peripheral devices 84 such as disk units. Similarly, a communications adapter 85 is provided for connecting the workstation to external processors (eg. a host computer). A keyboard 87 is connected to the system bus via a keyboard adapter 86. The display adapter 90 is used for controlling the display of data on a display device 94.

The workstation performs a wide variety of tasks. One class of task is the generation of lines in graphics application. This can be done by an iterative algorithm generally known as Bresenham's Line Algorithm. The algorithm consists in defining an initial horizontal and vertical line location, then for each horizontal address location calculates an error term which determines whether a step should be made in the orthogonal direction. While very efficient, plotting performance of such algorithms is constrained in prior art displays due to the frame buffer memory technology, which allows page mode pixel storage only in the horizontal direction. Random cycle performance occurs during every orthogonal change with worst case performance (vertical line draw) approaching random cycle timings. However, a display memory using random access memory in accordance with the invention, can achieve plotting performance approaching page mode frequencies. The operations required for updating a line in a display system having a frame buffer comprised of a random access memory in accordance with the invention are summarised below:
A. Determine initial row and column addresses for a starting point on the line and a direction for subsequent points on the line.
B. Generate a row change mode signal representative of that direction for subsequent points of the line and supply the mode signal and the initial row address to the memory when a row address strobe becomes active; thus setting the memory in an appropriate row change mode and selecting an initial row address.
C. When a first column address strobe becomes active, supply the initial column address to the memory for accessing a location specified by the initial row and column addresses and for plotting pixel data at that location.
D. Determine, in accordance with the incremental line drawing algorithm, the column address for a subsequent point on the line and an error term which is used as a row change signal, indicating whether, or not, a row change is required for the subsequent point.
E. Supply the column address and row change signal to the memory when a subsequent column address strobe becomes active for accessing the appropriate location for that subsequent point and for plotting pixel data at that location.
F. Repeat steps (D) and (E) for subsequent points on the line until the line update is complete.

Although described above with respect to specific examples, the invention is not limited thereto, and many additions and modifications are possible within the scope of the claimed invention.

For example, although the mode signal and the row change signal are both supplied on a shared RC line at their appropriate timings, they could be supplied on separate dedicated lines, or on lines which are otherwise not used at the timings in question. In memories such as that described above, requiring more row address bits than column address bits, the row change signal could be supplied on one of address lines not used during the column cycles. If moreover, the mode signal is supplied on an input (eg. a function pin) for the memory which is unused when RAS becomes active, or by coding signals on other inputs, or from data in a register, it can then be seen that the invention can be implemented without requiring a special input line to the memory for the mode and row change signals.

Also, in the described example, the choice of row change mode is between a row increment and a row decrement mode. However, different row change modes could be defined. For example the choice may be between a positive and zero row increment. This choice might be desirable for simulating double length rows. Also, the control means could be designed to respond to a multibit row change signal whereby a choice of more than two row change modes could be offered. Also, control means could be implemented whereby the direction and/or magnitude of row changes may be altered during the page mode cycle. Where such a memory were used in a graphics display system this would give a high degree of flexibility for plotting curves, circles, arcs or other complex graphical shapes, whilst maintaining the performance benefits of page mode.

## Claims

1. Memory addressable by row and by column and operable in page mode such that a row address is selected for a row cycle and within said row cycle a plurality of column cycles are performed to access the memory at selected column addresses, characterised in that said memory additionally comprises control means (2,4) for stepping the row address for selected column cycles within said row cycle.

2. A memory as claimed in claim 1 wherein said control means is responsive to a row change signal (RC) supplied to said memory when a column address strobe (CAS) becomes active for stepping said row address.

3. A memory as claimed in claim 2 wherein said control means is responsive to a mode signal (RC) supplied to said memory when a row address strobe (RAS) becomes active to set said memory in a selected row change mode, said row change mode defining a row address step performed by said control means in response to said row change signal.

4. A memory as claimed in claim 3 wherein said control means sets said memory in either a row increment mode or a row decrement mode in response to said mode signal, and wherein said control means is responsive to a row address supplied to said memory when said row address strobe becomes active for activating the row selected by said row address and at least one further row having a higher address in a row increment mode or a lower address in a row decrement mode.

5. A memory as claimed in claim 4 wherein said control means is responsive to said row change signal either, in a row increment mode to deactivate the row having the lowest address currently activated and to activate a row having yet a higher address or, in a row decrement mode to deactivate the row having the highest address currently activated and to activate a row having yet a lower address.

6. A memory as claimed in claim 5 wherein said memory is segmented into at least two segments, and wherein said control means is arranged such that a maximum of one row in each segment may be in an activated state for a column cycle.

7. Display memory for a display system comprising memory as claimed in any preceding claim.

8. Display system having a display memory as claimed in claim 7.

9. A method of accessing a memory addressable by row and by column and operable in page mode such that a row address is selected for a row cycle and within said row cycle a plurality of column cycles are performed to access the memory at selected column addresses, characterised in that said method changes the row accessed for selected column accesses by comprising the steps of:
a) setting the memory in a selected row change mode in response to a mode signal (RC) which is supplied to the memory when a row address strobe (RAS) becomes active, said row change mode defining a row address step to be performed in response to a row change signal (RC); and
b) stepping the row address as defined by the row change mode in response to said row change signal (RC) supplied to the memory when a column address strobe (CAS) becomes active.

10. A method as claimed in claim 9 wherein step (a) additionally comprises the sub-step of:
(a)(i) responding to a row address supplied to the memory when said row address strobe becomes active to activate the row selected by the row address and at least one further row having a higher address in a first mode or at least one further address having a lower address in a second mode.

11. A method as claimed in claim 10 wherein step (b) additionally comprises the sub-step of:
(b)(i) responding to a row change signal supplied to the memory when a column address strobe becomes active either, in said first mode to deactivate the row having the lowest address currently activated and to activate a further row having yet a higher address or, in said second mode to deactivate the row having the highest address currently activated and to activate a further row having a yet lower address.

12. A method of plotting a line in a display system as claimed in claim 8 comprising the steps of:
(a) determining initial row and column addresses for a starting point on the line and a direction for subsequent points on the line;
(b) generating a row change mode signal representative of said direction for subsequent points of the line and supplying said mode signal and said initial row address to said memory when a row address strobe becomes active for setting said memory in an appropriate row change mode and for selecting a row address;
(c) when a first column address strobe becomes active, supplying said initial column address to said memory for accessing a location specified by said initial row and column addresses and for plotting pixel data at that location;
(d) determining, in accordance with an incremental line drawing algorithm, a column address for a subsequent point on the line and a row change signal, the value of which determines whether, or not, a row change is required for said subsequent point;
(e) supplying said column address and row change signal to said memory when a subsequent column address strobe becomes active for accessing an appropriate location for said subsequent point and for plotting pixel data at that location;
(f) repeating steps (d) and (e) for subsequent points on the line.

## Patentansprüche

1. Ein Speicher, der reihenweise und spaltenweise adressierbar ist und im Seitenmodus betrieben werden kann, so daß für einen Reihenzyklus eine Reihenadresse ausgewählt wird und innerhalb dieses Reihenzyklus mehrere Spaltenzyklen zum Zugriff auf den Speicher an ausgewählten Spaltenadressen durchgeführt werden, dadurch gekennzeichnet, daß der Speicher ein zusätzliches Steuerungsmittel (2, 4) zur Fortschaltung der Reihenadresse für ausgewählte Spaltenzyklen innerhalb des Reihenzyklus umfaßt.

2. Ein Speicher nach Anspruch 1, bei dem das Steuerungsmittel auf ein Reihenwechselsignal (RC) anspricht, das dem Speicher zugeleitet wird, wenn ein Spaltenadressierungsimpuls (CAS) zum Fortschalten der Reihenadresse aktiv wird.

3. Ein Speicher nach Anspruch 2, bei dem das Steuerungsmittel auf ein Modussignal (RC) anspricht, das dem Speicher zugeleitet wird, wenn ein Reihenadressierungsimpuls (RAS) zum aktiv wird, um den Speicher in einen ausgewählten Reihenwechselmodus zu versetzen, wobei der Reihenwechselmodus eine Reihenadreßfortschaltung definiert, die durch das Steuerungsmittel als Reaktion auf das Reihenwechselsignal durchgeführt wird.

4. Ein Speicher nach Anspruch 3, bei dem das Steuerungsmittel den Speicher als Reaktion auf das Modussignal entweder in einen Reihendekrementmodus oder in einen Reiheninkrementmodus versetzt und bei dem das Steuerungsmittel auf eine Reihenadresse anspricht, die dem Speicher zugeleitet wird, wenn der Reihenadressierungsimpuls aktiv wird, um die von der Reihenadresse gewählte Reihe und zumindest eine weitere Reihe, die im Reiheninkrementmodus eine höhere Adresse oder im Reihendekrementmodus eine niedrigere Adresse hat, zu aktivieren.

5. Ein Speicher nach Anspruch 4, bei dem das Steuerungsmittel auf das Reihenwechselsignal anspricht, um entweder, in einem Reiheninkrementmodus, die Reihe mit der niedrigsten derzeit aktivierten Adresse zu deaktivieren und eine Reihe mit einer noch höheren Adresse zu aktivieren oder, in einem Reihendekrementmodus, die Reihe mit der höchsten derzeit aktivierten Adresse zu deaktivieren und eine Reihe mit einer noch niedrigeren Adresse zu aktivieren.

6. Ein Speicher nach Anspruch 5, bei dem der Speicher in mindestens zwei Segmente segmentiert ist und bei dem das Steuerungsmittel so arrangiert ist, daß höchstens eine Reihe in jedem Segment in einem aktivierten Zustand für einen Spaltenzyklus sein kann.

7. Ein Anzeigespeicher für ein Anzeigesystem mit einem Speicher nach einem der vorangegangenen Ansprüche.

8. Ein Anzeigesystem mit einem Speicher nach Anspruch 7.

9. Ein Verfahren zum Zugreifen auf einen Speicher, der reihenweise und spaltenweise adressierbar ist und im Seitenmodus betrieben werden kann, so daß für einen Reihenzyklus eine Reihenadresse ausgewählt wird und innerhalb dieses Reihenzyklus mehrere Spaltenzyklen zum Zugriff auf den Speicher an ausgewählten Spaltenadressen durchgeführt werden, dadurch gekennzeichnet, daß das Verfahren die Reihe wechselt, auf die zwecks ausgewählter Spaltenzugriffe zugegriffen wurde, indem es folgende Schritte umfaßt:
(a) Versetzen des Speichers in einen ausgewählten Reihenwechselmodus als Reaktion auf ein Modussignal (RC), das dem Speicher zugeleitet wird, wenn ein Reihenadressierungsimpuls (RAS) aktiv wird, wobei der Reihenwechselmodus eine Reihenadreßfortschaltung definiert, die als Reaktion auf ein Reihenwechselsignal (RC) durchgeführt werden soll; und
(b) Fortschalten der Reihenadresse, wie durch den Reihenwechselmodus definiert, als Reaktion auf das Reihenwechselsignal (RC), das dem Speicher zugeleitet wird, wenn ein Spaltenadressierungsimpuls (CAS) aktiv wird.

10. Ein Verfahren nach Anspruch 9, wobei der Schritt (a) zusätzlich folgenden Unterschritt umfaßt:
(a) (i) Reagieren auf eine Reihenadresse, die dem Speicher zugeleitet wird, wenn der Reihenadressierungsimpuls aktiv wird, um die von der Reihenadresse ausgewählte Reihe sowie in einem ersten Modus mindestens eine weitere Reihe mit höherer Adresse oder in einem zweiten Modus mindestens eine weitere Reihe mit niedrigerer Adresse zu aktivieren.

11. Ein Verfahren nach Anspruch 10, wobei der Schritt (b) zusätzlich folgenden Unterschritt umfaßt:
(b) (i) Reagieren auf ein Reihenwechselsignal, das dem Speicher zugeleitet wird, wenn ein Spaltenadressierungsimpuls aktiv wird, um entweder, in dem ersten Modus, die Reihe mit der niedrigsten derzeit aktivierten Adresse zu deaktivieren und eine weitere Reihe mit einer noch höheren Adresse zu aktivieren oder, in dem zweiten Modus, die Reihe mit der höchsten derzeit aktivierten Adresse zu deaktivieren und eine weitere Reihe mit einer noch niedrigeren Adresse zu aktivieren.

12. Ein Verfahren zum Zeichnen einer Linie in einem Anzeigesystem nach Anspruch 8, das folgende Schritte umfaßt:
(a) Festlegen einer Reihen- und Spalten-Ausgangsadresse für einen Ausgangspunkt auf der Linie und einer Richtung für nachfolgende Punkte auf der Linie;
(b) Erzeugen eines Reihenwechselmodussignals, das diese Richtung für nachfolgende Punkte auf der Linie bezeichnet, und Zuleiten des Modussignals und der Reihenausgangsadresse zu dem Speicher, wenn ein Reihenadressierungsimpuls aktiv wird, um den Speicher in einen entsprechenden Reihenwechselmodus zu versetzen und eine Reihenausgangsadresse auszuwählen;
(c) wenn ein erster Spaltenadressierungsimpuls aktiv wird, Zuleiten der Spaltenausgangsadresse zu dem Speicher, um auf eine von der Reihen- und Spaltenausgangsadresse angegebene Position zuzugreifen und Pixeldaten an dieser Position zu zeichnen;
(d) anhand eines inkrementellen Linienzeichenalgorithmus Festlegen einer Spaltenadresse für einen nachfolgenden Punkt auf der Linie und eines Reihenwechselsignals, dessen Wert bestimmt, ob für den nachfolgenden Punkt ein Reihenwechsel erforderlich ist oder nicht;
(e) Zuleiten der Spaltenadresse und des Reihenwechselsignals zu dem Speicher, wenn ein nachfolgender Spaltenadressierungsimpuls aktiv wird, um auf eine entsprechende Position für den nachfolgenden Punkt zuzugreifen und an dieser Position Pixeldaten zu zeichnen;
(f) Wiederholen der Schritte (d) und (e) für nachfolgende Punkte auf der Linie.

## Revendications

1. Mémoire adressable par rangée et par colonne et pouvant fonctionner en mode de page de sorte qu'une adresse de rangée soit sélectionnée pour un cycle de rangée et, dans ledit cycle de rangée, une pluralité de cycles de colonne est accomplie pour avoir accès à la mémoire aux adresses de colonne sélectionnées, caractérisée en ce que ladite mémoire comprend en outre des moyens de contrôle (2,4) pour faire progresser l'adresse de rangée des cycles de colonne sélectionnés dans ledit cycle de rangée.

2. Mémoire selon la revendication 1, dans laquelle lesdits moyens de contrôle sont sensibles à un signal de changement de rangée (RC) fourni à ladite mémoire lorsqu'une impulsion d'adresse de colonne devient active pour faire progresser ladite adresse de rangée.

3. Mémoire selon la revendication 2, dans laquelle lesdits moyens de contrôle sont sensibles à un signal de mode RC fourni à ladite mémoire lorsqu'une impulsion d'adresse de rangée (RAS) devient active pour instaurer ladite mémoire dans un mode de changement de rangée sélectionné, ledit mode de changement de rangée définissant une étape d'adresse de rangée accomplie par lesdits moyens de contrôle en réponse audit signal de changement de rangée.

4. Mémoire selon la revendication 3, dans laquelle lesdits moyens de contrôle instaurent ladite mémoire soit dans un mode d'incrémentation de rangée soit dans un mode de décrémentation de rangée en réponse audit signal de mode, et dans laquelle lesdits moyens de contrôle sont sensibles à une adresse de rangée fournie à ladite mémoire lorsque ladite impulsion d'adresse de rangée devient active pour rendre active la rangée sélectionnée par ladite adresse de rangée et au moins une autre rangée ayant une adresse supérieure dans un mode d'incrémentation de rangée ou une adresse inférieure dans un mode de décrémentation de rangée.

5. Mémoire selon la revendication 4, dans laquelle lesdits moyens de contrôle sont sensibles audit signal de changement de rangée soit dans un mode d'incrémentation de rangée pour rendre inactive la rangée ayant l'adresse inférieure alors active et pour rendre active une rangée ayant auparavant une adresse supérieure soit dans un mode de décrémentation de rangée pour rendre inactive la rangée ayant l'adresse supérieure alors active et pour rendre active une rangée ayant auparavant une adresse inférieure.

6. Mémoire selon la revendication 5, dans laquelle ladite mémoire est divisée en au moins deux segments, et dans laquelle lesdits moyens de contrôle sont agencés de sorte qu'un maximum de une rangée dans chaque segment puisse être dans un état actif pour un cycle de colonne.

7. Mémoire d'affichage pour système d'affichage comprenant une mémoire selon l'une quelconque des revendications précédentes.

8. Système d'affichage ayant une mémoire d'affichage selon la revendication 7.

9. Procédé d'accès à une mémoire adressable par rangée et par colonne et pouvant fonctionner en mode de page de sorte qu'une adresse de rangée soit sélectionnée pour un cycle de rangée et, dans ledit cycle de rangée, une pluralité de cycles de colonne est accomplie pour avoir accès à la mémoire à des adresses de colonne sélectionnées, caractérisée en ce que ledit procédé change la rangée à laquelle il y a eu accès pour des accès de colonne sélectionnés en comprenant les étapes de:
a) instaurer la mémoire dans un mode de changement de rangée sélectionné en réponse à un signal de mode (RC) qui est envoyé à la mémoire lorsqu'une impulsion d'adresse de rangée devient active, ledit mode de changement de rangée définissant une étape d'adresse de rangée à accomplir en réponse à un signal de changement de rangée (RC); et
b) faire progresser l'adresse de rangée telle que définie par le mode de changement de rangée en réponse audit signal de changement de rangée (RC) fourni à la mémoire lorsqu'une impulsion d'adresse de colonne (CAS) devient active.

10. Procédé selon la revendication 9, dans lequel l'étape a) comprend en outre la sous-étape de:
(a) (i) répondre à une adresse de rangée fournie à la mémoire lorsque ladite impulsion d'adresse de rangée devient active pour rendre active la rangée sélectionnée par l'adresse de rangée et au moins une autre rangée ayant une adresse supérieure dans un premier mode ou au moins une autre adresse ayant une adresse inférieure dans un deuxième mode.

11. Procédé selon la revendication 10, dans lequel l'étape (b) comprend en outre la sous-étape de:
(b) (i) répondre à un signal de changement de rangée fourni à la mémoire lorsqu'une impulsion d'adresse de colonne devient active soit dans ledit premier mode pour rendre inactive la rangée ayant l'adresse inférieure alors active et pour rendre active une autre rangée ayant auparavant une adresse supérieure soit dans ledit deuxième mode pour rendre inactive la rangée ayant l'adresse supérieure alors active et pour rendre active une autre rangée ayant auparavant une adresse inférieure.

12. Procédé pour tracer une ligne dans un système d'affichage selon la revendication 8, comprenant les étapes de:
(a) déterminer des adresses de rangée et de colonne initiales pour un point de départ sur la ligne et une direction pour d'autres points sur la ligne;
(b) engendrer un signal de mode de changement de rangée représentant ladite direction d'autres points de la ligne et fournir ledit signal de mode et ladite adresse de rangée initiale à ladite mémoire lorsqu'une impulsion d'adresse de rangée devient active pour instaurer ladite mémoire dans un mode de changement de rangée approprié et pour sélectionner une adresse de rangée;
(c) lorsqu'une première impulsion d'adresse de colonne devient active, fournir ladite adresse de colonne initiale à ladite mémoire pour avoir accès à une position spécifiée par lesdites adresses de rangée et de colonne initiales et tracer les données pixel à cette position;
(d) déterminer, conformément à un algorithme de tirage de ligne par incrément, une adresse de colonne d'un autre point sur la ligne et un signal de changement de rangée dont la valeur détermine s'il faut, ou non, un changement de rangée pour ledit autre point;
(e) fournir lesdits adresse de colonne et signal de changement de rangée à ladite mémoire lorsqu'une autre impulsion d'adresse de colonne devient active pour l'accès à une position appropriée dudit autre point et pour tracer des données pixel à cette position;
(f) répéter les étapes (d) et (e) pour d'autres points sur la ligne.
